Europäisches Patentamt

European Patent Office

Office européen des brevets

(11) Veröffentlichungsnummer: **0 188 263**
**A1**

(12) **EUROPÄISCHE PATENTANMELDUNG**

(21) Anmeldenummer: 86100377.0

(22) Anmeldetag: 13.01.86

(51) Int. Cl.⁴: **H03H 9/145** , H03H 9/64

(30) Priorität: 14.01.85 DE 3500996

(43) Veröffentlichungstag der Anmeldung:
23.07.86 Patentblatt 86/30

(84) Benannte Vertragsstaaten:
BE DE FR GB IT NL

(71) Anmelder: **Siemens Aktiengesellschaft**
**Berlin und München Wittelsbacherplatz 2**
**D-8000 München 2(DE)**

(72) Erfinder: **Albrecht, Gunnar, Dr.rer.nat.,Dipl.-Phys.**
**Feulnerweg 30**
**D-8000 München 83(DE)**
Erfinder: **Faber, Werner, Dr.Ing.,Dipl.-Phys.**
**Erlenweg 4**
**D-8011 Kirchheim(DE)**

(54) Elektrisches Oberflächenwellenfilter.

(57) Oberflächenwellenfilter mit einer Übertragungsfunktion mit geringstmöglichem Triple-Transit-Echo und mit mindestens einem Wandler, dessen Fingerstruktur durch folgende Maßnahme bestimmt ist:

a) die Übertragungsfunktion wird anteilig auf die Wandler aufgeteilt,

b) die aufgeteilte Übertragungsfunktion wird in die entsprechende anteilige Zeitbereichsfunktion h (t) umgesetzt, wobei die Tiefpaßzeitbereichsantwort $h_p$ (t) bzw. $h_q$ (t) durch geeignete Wahl der Modulationsfrequenz $f_0$ bestimmt ist,

c) die Zeitbereichsfunktion h (t) wird in eine neue anteilige Zeitbereichsfunktion $h_N$ (t) = h (t + $t_i$) - h (t - $t_i$) umgewandelt, wobei $t_i$ kleiner als das Minimum von $T_{oi}$ gewählt und $T_{oi} \geq \dfrac{1}{2f_o}$ ist,

d) die Zeitbereichsfunktion $h_N$ (t) wird mit mindestens zwei Folgen äquidistanter δ-Impulse abgetastet und damit jeweils die Überlappungslänge aufeinanderfolgender Finger eines Wandlers ermittelt, wobei zwischen den Folgen die Verschiebung 2 $t_i$ und innerhalb jeder Folge der zeitliche Abstand benachbarter δ-Impulse $T_{oi}$ beträgt und $T_{oi} \geq \dfrac{1}{2f_o}$ ist.

FIG 2b

## Elektrisches Oberflächenwellenfilter

Die Erfindung betrifft ein Oberflächenwellenfilter gemäß Oberbegriff des Patentanspruches 1.

Oberflächenwellenfilter sind z. B. durch das Datenbuch "Oberflächenwellen-Filter LIOB", Ausgabe 1983/84, Herausgeber Siemens, bekannt. Sie stellen integrierte, passive Bauelemente mit Bandfiltercharakteristik dar, deren Funktion auf der Interferenz von mechanischen Oberflächen beruht, die sich längs der Oberfläche eines piezoelektrischen Materials ausbreiten. Ihr Aufbau zeichnet sich durch ein einkristallines, piezoelektrisches Substrat, vorzugsweise ein Lithiumniobat-Substrat aus, auf das eine Metallschicht, normalerweise Aluminiumschicht aufgetragen, z. B. aufgedampft ist, aus der mittels Fotoätztechnik piezoelektrische Ein- und Ausgangswandler, sog. Interdigitalwandler herausgearbeitet sind. Diese bestehen aus mehreren metallisierten kammartigen Elektroden, d. h. aus Elektroden mit Sammelschienen und senkrecht zu diesen ausgerichteten Fingern, die sich in den aktiven Bereichen der Wandler jeweils mit Fingern der Elektroden unterschiedlicher Polarität überlappen. Das Substrat an sich ist auf einen Metallträger aufgeklebt. Die Kontaktierung der Ein- und Ausgangswandler mit den nach außen führenden Anschlüssen erfolgt dabei über Bonddrähte.

Im Betrieb dieser Oberflächenwellenfilter wird ein in den Eingangswandler eingegebenes elektrisches Signal in eine mechanische Oberflächenwelle umgewandelt, die auf der Oberfläche bzw. in der oberflächennahen Schicht des Substrats zum Ausgangswandler läuft, der die Oberflächenwelle wiederum in ein elektrisches Signal umwandelt. Die üblichen Wandler besitzen Interdigitalstrukturen mit Laufzeiteffekten und zeichnen sich durch stark frequenzabhängige Eigenschaften aus, so daß aufgrund entsprechender Ausbildung der Fingerstrukturen der Wandler eine Filterwirkung für elektrische Signale erreichbar ist.

Die elektrischen Eigenschaften der Oberflächenwellenfilter, die aus zwei Interdigitalwandlern bestehen, werden wesentlich durch zwei Parameter bestimmt, nämlich durch die Durchgangsdämpfung bzw. Durchlaßkurve, d. h. die über der Frequenz aufgetragene Dämpfung und durch die Dämpfung des Triple-Transit--Echos, auch TTE genannt (siehe das eingangs genannte Datenbuch, Seite 12), das ein für Oberflächenwellenfilter typisches Störsignal ist. Eine vom Eingangswandler auf den Ausgangswandler auftreffende Oberflächenwelle wird nämlich vom Ausgangswandler reflektiert, läuft zurück zum Eingangswandler, wird von diesem wieder reflektiert und erscheint schließlich als Echosignal mit dreifacher Grundlaufzeit am Filterausgang. Beide Parameter sind miteinander über die 3-Tor Eigenschaften der Interdigitalwandler und durch die externe Beschaltung, z. B. Treiberstufen, Integrierte Schaltungen und dergleichen verknüpft.

Eine Änderung der Durchgangsdämpfung und somit auch des Echosignals ist nur durch Änderung der externen Beschaltung in einfacher Weise möglich. Liegt bei bekanntem Einkristallsubstrat die grundsätzliche Filterstruktur, d. h. die Art und Lage der Wandler sowie der Einsatz weiterer zur Signalverarbeitung von Oberflächenwellen geeigneter Komponenten, wie z. B. von Multistrip-Kopplern, fest und ist die externe Beschaltung nicht veränderbar, so kann eine Veränderung der vorstehenden Parameter nur durch Abänderung der inneren Struktur eines oder beider Wandler, d. h., z. B. durch Änderung des Wandlerabstandes, der Apertur oder Wichtung der Wandlerfinger erreicht werden.

Die vorliegende Erfindung hat diese Änderung der inneren Struktur eines oder beider Wandler und damit die mögliche Anpassung der Durchgangsdämpfung und somit des Triple-Transit-Echos an eine externe Beschaltung zum Gegenstand.

Die bisher bekannten Verfahren zur Festlegung der inneren Struktur, d. h. der Kammstruktur der Interdigitalwandler gehen bereits von der Überlegung aus, daß sich die zur Signalverarbeitung erwünschte Durchlaßkurve bzw. Filterbandpaßfunktion aus den Übertragungsfunktionen von zumindest zwei Wandlern zusammensetzt. Die Kammstruktur eines jeden Wandlers wird dabei durch die Zeitbereichsantwort der für diesen Wandler anteiligen Übertragungsfunktion bestimmt. Der Übergang von der kontinuierlichen Zeitbereichsantwort h (t) eines Wandlers zur kammartigen nichtkontinuierlichen Struktur $h_s$ (t) desselben Wandlers wird schließlich durch einen als "Samplingprocess" bezeichneten Abtastvorgang erreicht. Zu diesem Zweck wird die Zeitbereichsantwort h (t) in äquidistanten oder nichtäquidistanten Zeitintervallen abgegriffen und als Finger- bzw. Überlappungslängen realisiert.

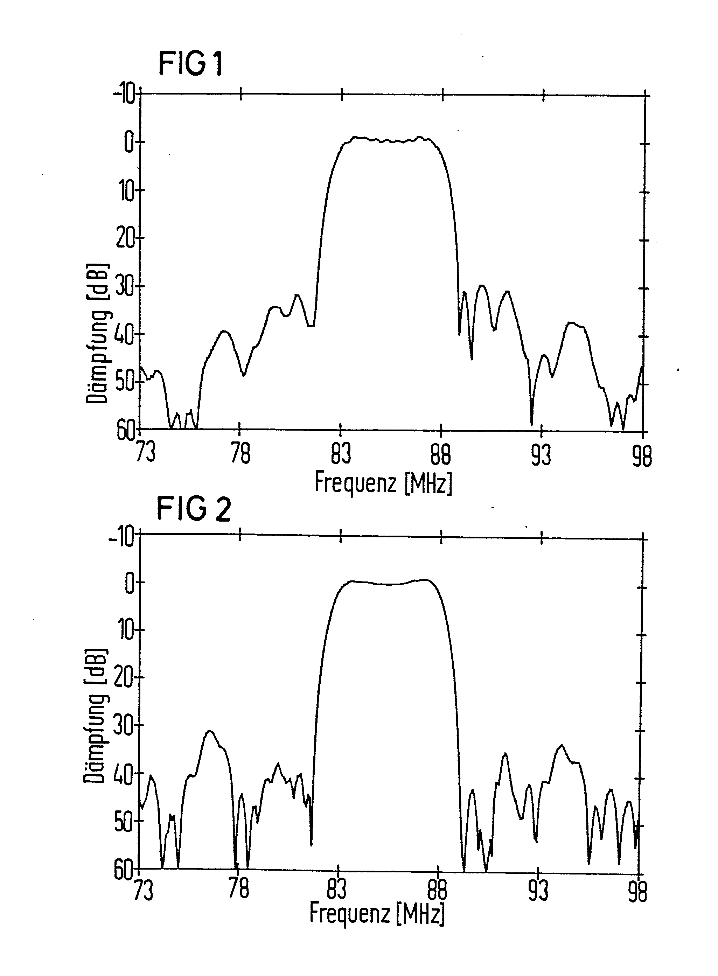

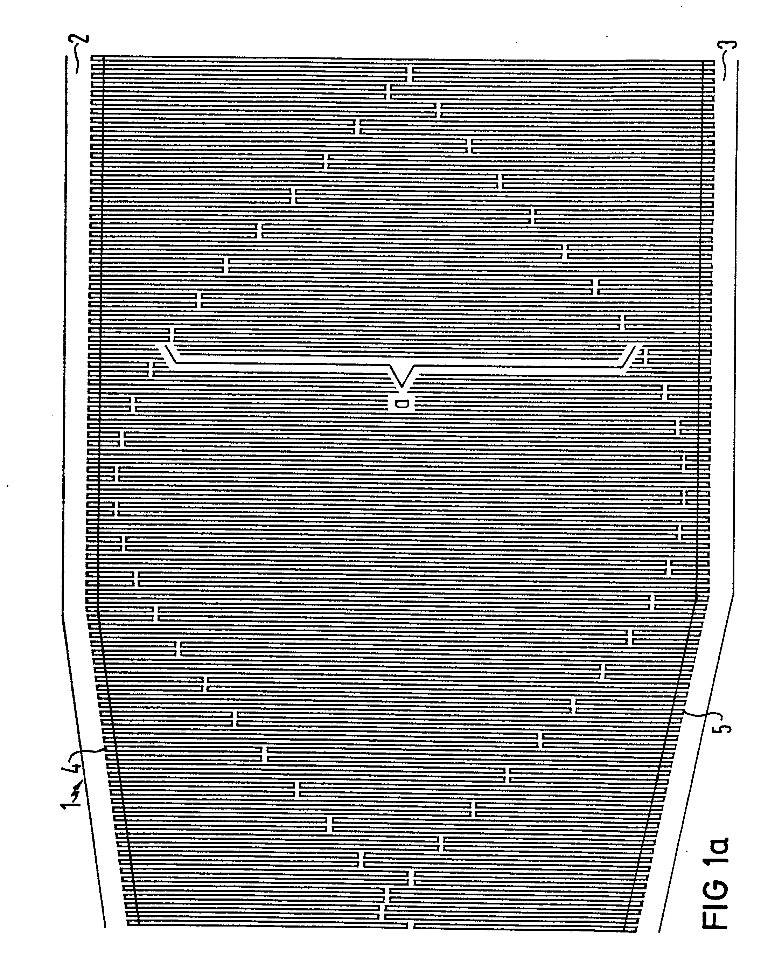

Eine gemessene Durchlaßkurve für ein Oberflächenwellenfilter, dessen beide Wandler nach vorstehender bekannter Methode realisiert wurden, ist z. B. in Fig. 1 dargestellt. Der eine der beiden Wandler, vorzugsweise der Ausgangswandler, ist dabei ungewichtet, d. h. die Überlappungslänge der benachbarten Finger unterschiedlicher Polarität ist konstant; wohingegen der andere, vorzugsweise der Eingangswandler 1 die in Fig. 1a dargestellte gewichtete kammartige Struktur besitzt. Mit 2 bzw. 3 sind dabei die Sammelschienen der Elektroden unterschiedlicher Polarität bezeichnet, deren Finger 4 bzw. 5 gewichtete, d. h. unterschiedliche Überlappungslängen "a" aufweisen.

Aufgrund zu geringer Dämpfung bei festliegender externer Beschaltung besitzt dieses Filter ein hohes Triple--Transit-Echo, das als starke Dachwelligkeit auf der Durchlaßkurve (Fig. 1) auftritt. Dieses Filter ist folglich für den Einsatz nicht bzw. nur bedingt geeignet.

Der vorliegenden Erfindung liegt die Aufgabe zugrunde eine gegenüber diesem Verfahren verbesserte Maßnahme zur Bestimmung der Fingerstruktur der Wandler anzugeben, welche die Schaffung eines elektrischen Oberflächenwellenfilters gemäß Oberbegriff des Patentanspruches mit vorgegebener Übertragungsfunktion mit geringstmöglichem Triple-Transit-Echo ermöglicht.

Die zur Lösung dieser Aufgabe erfindungsgemäß vorgeschlagene Maßnahme zeichnet sich durch nachstehende Reihenfolge von Schritten aus:

a) die vorgegebene bzw. gewünschte Übertragungsfunktion wird anteilig auf die Wandler aufgeteilt,

b) die anteilige Übertragungsfunktion je Wandler wird in die entsprechende anteilige Zeitbereichsfunktion

$$h (t) = h_p (t) \cdot \cos (2 \pi f_0 \cdot t) + h_q (t) \cdot \sin (2 \pi f_0 \cdot t)$$

umgesetzt,

wobei die Tiefpaßzeitbereichsantwort $h_p$ (t) bzw. $h_q$ (t) durch geeignete Wahl von $f_0$ ( = Modulationsfrequenz) bestimmt ist,

c) die anteilige Zeitbereichsfunktion h (t) wird umgewandelt in eine neue anteilige Zeitbereichsfunktion

$h_N(t) = h(t + t_1) - h(t - t_1)$, wobei $t_1$ vorzugsweise kleiner als das Minimum von $T_{oi}$ gewählt und $T_{oi}$ wie folgt bestimmt ist $T_{oi} \geq \dfrac{1}{2f_O}$,

d) die anteilige Zeitbereichsfunktion $h_N$ (t) wird mit mindestens zwei Folgen äquidistanter $\delta$-Impulse abgetastet und damit jeweils die Überlappungslänge aufeinanderfolgender Finger eines Wandlers ermittelt, wobei zwischen den Folgen die Verschiebung $2 t_1$ und innerhalb jeder Folge der zeitliche Abstand benachbarter $\delta$-Impulse $T_{oi}$ beträgt und $T_{oi} \geq \dfrac{1}{2f_O}$ ist.

Die Abtastwerte der so gewonnenen nicht kontinuierlichen Zeitbereichsfunktion werden als Überlappungslängen oder Fingerlängen durch die kammartige Struktur des Interdigitalwandlers realisiert. Die Summe der Überlappungen stellt dabei in erster Näherung ein Maß für die Durchgangsdämpfung dar und bestimmt somit auch das Triple-Transit-Echo-Niveau.

Durch geeignete Wahl der Modulationsfrequenz $f_o$ gemäß Schritt d) und durch die Schritte c) und b) kann die Summe der Überlappungen der nichtkontinuierlichen Zeitbereichsfunktion variiert werden. Dies bedeutet letztlich, daß die Durchlaßkurve bzw. Durchlaßdämpfung und das Triple-Transit-Echo einstellbar sind.

Darüberhinaus kann durch die Wahl der in Schritt c) definierten Zeitverschiebung $t_1$ sowie durch Festlegung des gleichfalls in c) definierten zeitlichen Abstandes $T_{oi}$ innerhalb der i-ten Folge eine Kompensation von Reflexionen erreicht werden, die einerseits durch die Beschaltung und andererseits durch die Metallisierung der Interdigitalstruktur hervorgerufen werden.

Die Erfindung wird nachstehend anhand eines Ausführungsbeispieles für einen gewichteten Wandler näher erläutert, das zwar den gleichen Filtertyp gemäß Fig. 1, 1a zum Gegenstand hat, jedoch hinsichtlich der inneren Struktur seinen Wandler entsprechend der Maßnahme nach der Erfindung abgeändert wurde.

Es zeigt:

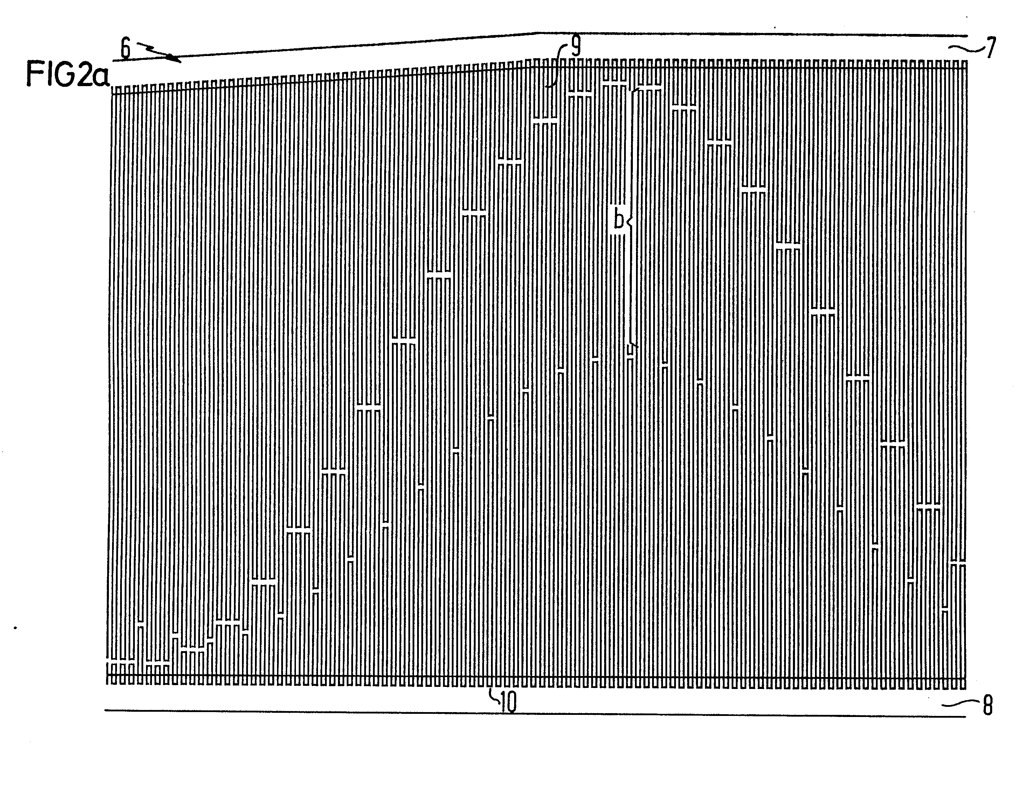

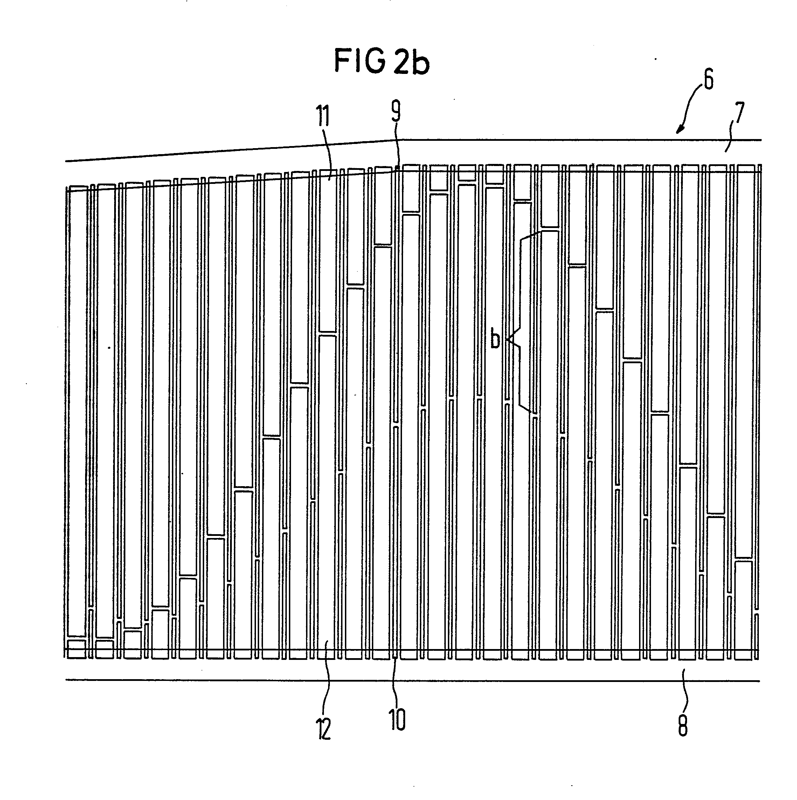

Fig. 2 die Durchlaßkurve für dieses entsprechend geänderte Oberflächenwellenfilter,

Fig. 2a die Fingerstruktur des gemäß der Maßnahme nach der Erfindung abgeänderten gewichteten Wandlers dieses Filters,

Fig. 2b gleichfalls die Fingerstruktur des gemäß der Maßnahme nach der Erfindung abgeänderten gewichteten Wandlers, wobei jedoch die benachbarten Finger gleicher Polarität und Länge zusammengefaßt sind.

Bei den in Fig. 1a und Fig. 2a bzw. Fig. 2b dargestellten Eingangswandlern 1 bzw. 6 handelt es sich um Wandler des gleichen Filtertyps. Die Sammelschienen der Elektroden unterschiedlicher Polarität der gemäß der Maßnahme nach der Erfindung strukturierten Wandler 6 nach Fig. 2a bzw. Fig. 2b sind mit 7 bzw. 8 und ihre Finger mit 9, 10 bzw. 9, 11 bzw. 10, 12 bezeichnet. Im Unterschied zur Fingerstruktur nach Fig. 2a sind im Wandler 6 gemäß Fig. 2b die benachbarten Finger gleicher Polarität und Länge zusammengefaßt (siehe Bezugszeichen 11 bzw. 12).

Die Modulationsfrequenz $f_o$ (siehe Schritt b) wurde so gewählt, daß - siehe die Durchlaßkurve gemäß Fig. 2 - sich eine Durchgangsdämpfung von ca. 20 dB einstellt. Die zeitliche Verschiebung $t_1$ beträgt im gezeigten Ausführungsbeispiel 3/8 $f_o$. Zur Abtastung gemäß Schritt d) der erfindungsgemäßen Maßnahme wurden zwei Folgen äquidistanter $\delta$-Impulse mit jeweils $T_{o1} = T_{o2} = 1/f_o$ gewählt. Die so erhaltene Durchlaßkurve gemäß Fig. 2 zeigt eine gegenüber der Durchlaßkurve nach Fig. 1 nur noch geringe Welligkeit, weshalb dieses Filter für den Einsatz geeignet ist.

## Ansprüche

1. Elektrisches Oberflächenwellenfilter mit vorgegebener Übertragungsfunktion mit geringstmöglichem Triple-Transit-Echo, mit einem piezoelektrischen Substrat mit mindestens zwei auf seiner Oberfläche angeordneten Wandlern, von denen mindestens einer gewichtet ist, d. h. der Wandlerfinger mit unterschiedlicher Überlappungslänge und gegebenenfalls mit unterschiedlichem Fingerabstand (Fingerstruktur) aufweist, **dadurch gekennzeichnet,** daß die Fingerstruktur zumindest eines Wandlers durch folgende Maßnahme bestimmt ist:

a) die vorgegebene Übertragungsfunktion wird anteilig auf die Wandler aufgeteilt,

b) die anteilige Übertragungsfunktion je Wandler wird in die entsprechende anteilige Zeitbereichsfunktion

$$h(t) = h_p(t) \cdot \cos(2\pi f_0 \cdot t) + h_q(t) \cdot \sin(2\pi f_0 \cdot t)$$

umgesetzt,

wobei die Tiefpaßzeitbereichsantwort $h_p(t)$ bzw. $h_q(t)$ durch geeignete Wahl von $f_o$ (= Modulationsfrequenz) bestimmt ist,

c) die anteilige Zeitbereichsfunktion h (t) wird umgewandelt in eine neue anteilige Zeitbereichsfunktion

$$h_N(t) = h(t + t_1) - h(t - t_1),$$

wobei $t_1$ vorzugsweise kleiner als das Minimum von $T_{oi}$ gewählt und $T_{oi}$ wie folgt bestimmt ist $T_{oi} \geq \dfrac{1}{2f_O}$,

d) die anteilige Zeitbereichsfunktion $h_N$ (t) wird mit mindestens zwei Folgen äquidistanter $\delta$-Impulse abgetastet und damit jeweils die Überlappungslänge aufeinanderfolgender Finger eines Wandlers ermittelt, wobei zwischen den Folgen der Verschiebung $2 t_1$ und innerhalb jeder Folge der zeitliche Abstand benachbarter $\delta$-Impulse $T_{oi}$ beträgt und $T_{oi} \geq \dfrac{1}{2f_O}$ ist.

## FIG 1

## FIG 2

FIG 1a

0 188 263

FIG 2a

FIG 2b

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-2 123 637 (MURATA MANUFACTURING CO., LTD.) * Insgesamt * | 1 | H 03 H 9/145 H 03 H 9/64 |
| | ----- | | |

RECHERCHIERTE
SACHGEBIETE (Int. Cl.4)

H 03 H

Der vorliegende Recherchenbericht wurde für alle Patentansprüche erstellt.

| Recherchenort | Abschlußdatum der Recherche | Prüfer |
|---|---|---|
| DEN HAAG | 09-04-1986 | DECONINCK E.F.V. |